# EUROPEAN PATENT APPLICATION

(11) **EP 4 769 091 A1**
(43) Date of publication of application: **01.07.2026**
(21) Application number: 25227707.4
(22) Date of filing: 30.12.2025
(51) Int. Cl.: G06F 3/041, G06F 3/044

(54) **DISPLAY DEVICE**

(30) Priority: 30.12.2024 KR 20240200344
(71) Applicant: LG Display Co., Ltd., Seoul, 07336 (KR)
(72) Inventor: GWON, Hyang Myoung, 10845 Paju-si (KR); JUNG, Ji Hyun, 10845 Paju-si (KR); RHE, Ru Da, 10845 Paju-si (KR)
(74) Representative: Morrall, Jonathan Ian McLachlan

(57) **Abstract**

Disclosures disclose a display device including: a substrate; a plurality of pixels disposed on the substrate; a plurality of touch electrodes disposed on the encapsulation portion; and a black matrix disposed on the plurality of touch electrodes, wherein the plurality of touch electrodes include a plurality of first opening holes that expose each of the plurality of pixels and a second opening hole larger than the plurality of first opening holes..

## Description

### CROSS-REFERENCE TO RELATED APPLICATION

This application claims priority to and the benefit of Korean Patent Application No. 10-2024-0200344, filed on December 30, 2024, the disclosure of which is incorporated herein by reference in its entirety.

### 1. Technical Field

The present disclosure relates to a display device. A particular embodiment of the present disclosure provides a display device including touch electrodes disposed on a display panel and a black matrix overlapping the touch electrodes.

### 2. Background Art

In order to provide various functions to a user, a display device recognizes a touch of a user's finger or pen on a display panel and performs input processing based on the recognized touch.

The display device may include a plurality of touch electrodes disposed on the display panel. The display device may drive the plurality of touch electrodes and detect a change in capacitance which occurs when the user touches the display panel, thereby sensing a user's touch.

In the display device, an area of the touch electrode needs to be increased to increase touch sensing sensitivity, but there are limitations in that the touch electrode is visible from the outside and the area of the touch electrode is limited in a manufacturing process. For instance, with the development of high-resolution (such as 2K, 4K, and even 8K) and high pixel density (PPI) display devices, the physical space occupied by each pixel is getting smaller. Touch electrodes usually need to be positioned between different pixels, which always limit the electrode size to the range of capabilities of the manufacturing process.

The description provided in the background section should not be assumed to be prior art merely because it is mentioned in or associated with this section.

The background section may include information that describes one or more aspects of the subject technology, and the description in this section does not limit the scope of the present disclosure.

### SUMMARY OF THE INVENTION

Due to limitations and disadvantages of the related art, there is a need for improvement in touch sensing structures of display devices.

Accordingly, the present disclosure is directed to a display device that substantially obviates one or more of the issues due to limitations and disadvantages of the related art.

An aspect of the present disclosure is directed to providing a display device including a touch electrode with an increased area without being visible from the outside.

Another aspect of the present disclosure is directed to providing a display device in which an area of the touch electrode is adjustable depending on vacuum equipment.

The objects of the present disclosure are not limited to the above-described objects, and other objects that are not mentioned will be clearly understood by those skilled in the art from the following description.

A display device according to one aspect of the present disclosure includes: a substrate; a plurality of pixels disposed on the substrate; an encapsulation portion disposed on the plurality of pixels; a plurality of touch electrodes disposed on the encapsulation portion; and a black matrix disposed on the plurality of touch electrodes, wherein the plurality of touch electrodes include a plurality of first opening holes that expose the plurality of pixels respectively, and a second opening hole larger than the plurality of first opening holes.

The plurality of touch electrodes may be disposed to overlap the black matrix.

Each of the plurality of first opening holes may expose one pixel, and the plurality of first opening holes may have different sizes from each other.

The second opening hole may expose more pixels than the first opening hole.

The plurality of touch electrodes may include a plurality of first touch electrodes arranged in a first direction, and a plurality of second touch electrodes arranged in a second direction intersecting the first direction, and the second opening hole may be disposed in each of the plurality of first touch electrodes and second touch electrodes.

A total area of the second opening hole in the touch electrodes may be smaller than a total area of the plurality of first opening holes.

The display device may further include a mesh pattern disposed in the second opening holes, and the mesh pattern may be electrically connected to the touch electrode.

The display device may further include an auxiliary electrode disposed to overlap the second opening hole.

The display device may further include a bridge electrode connecting the plurality of second touch electrodes, and the auxiliary electrode may be disposed on the same layer as the bridge electrode.

The display device may further include: a first touch insulating layer disposed on the encapsulation portion; and a second touch insulating layer disposed on the bridge electrode and the auxiliary electrode, wherein the bridge electrode may electrically connect the plurality of second touch electrodes, and the auxiliary electrode may be electrically connected to the touch electrode formed with the second opening hole by a through hole disposed in the second touch insulating layer.

The auxiliary electrode may have a mesh shape.

A display device according to another disclosure of the present disclosure includes: a substrate; a plurality of pixels disposed on the substrate; an encapsulation portion disposed on the plurality of pixels; an auxiliary electrode disposed on the encapsulation portion; a touch insulating layer disposed on the auxiliary electrode; a plurality of touch electrodes disposed on the touch insulating layer; and a black matrix disposed on the plurality of touch electrodes, wherein the plurality of touch electrodes include a second opening hole that exposes the auxiliary electrode.

The plurality of touch electrodes may further include a plurality of first opening holes that expose each of the plurality of pixels, and the second opening hole may be larger than the plurality of first opening holes.

The auxiliary electrode may further include a plurality of third opening holes that expose each of the plurality of pixels, and the third opening holes may be larger than the first opening holes. Each of the plurality of first opening holes may expose one pixel, and the plurality of first opening holes may have different sizes from each other.

In the embodiments of the present disclosure, the exposing may refer to ensuring that the touch electrode does not cover the pixel or auxiliary electrode.

The black matrix may cover an upper surface and side surface of the touch electrodes.

In another aspect, the present disclosure may provide a display device comprising: a substrate; a plurality of pixels disposed on the substrate; a plurality of touch electrodes disposed over the plurality of pixels; and a black matrix disposed on the plurality of touch electrodes, wherein the plurality of touch electrodes include: a first region having a first touch electrode and a second touch electrode; and a second region not having the first touch electrode and the second touch electrode; wherein the area of the second region is different from the area of the first region.

In some embodiments, the first touch electrode is disposed along a first direction and the second touch electrode is disposed along a second direction different from the first direction and the first touch electrode is disposed on a same layer of or a different layer from the second touch electrode.

The first region includes a plurality of first opening holes, and the plurality of first opening holes overlap with a plurality of pixels, respectively; the second region includes a second opening hole, and the second opening hole overlaps with a greater number of pixels than the first opening; and the area of the second region is smaller than the area of the first region.

An auxiliary electrode may be also disposed in the second region, the auxiliary electrode being disposed on a different layer from the touch electrode.

In another embodiment, the plurality of pixels includes a red pixel, green pixel, and blue pixel, and one of the plurality of first openings overlaps one of the red pixels, green pixels, and blue pixels, while the second opening overlaps a plurality of pixels among the red pixels, green pixels, and blue pixels.

The inventors of the present disclosure have recognized limitations of conventional display devices in which touch electrodes are visible and their areas are limited by manufacturing constraints, and have performed various experiments on touch electrodes disposed under a black matrix, which may allow an increased electrode area while maintaining low visibility and satisfying metal density requirements of vacuum equipment.

The display device according to the present disclosure may increase a touch sensing region while suppressing the visibility of touch electrodes from the outside, thereby improving touch sensitivity and display quality at the same time.

Another aspect of the present disclosure is to provide a display device which can be manufactured while adjusting an area of the touch electrode according to a metal density of vacuum equipment used in forming the electrodes.

Additional features and aspects will be set forth in part in the description that follows, and in part will become apparent from the description, or may be learned by practice of the inventive concepts provided herein.

It is to be understood that both the foregoing general description and the following detailed description are exemplary and explanatory and are intended to provide further explanation of the inventive concepts as claimed. Other systems, methods, features, and advantages will be, or will become, apparent to one with skill in the art upon examination of the following figures and detailed description.

It is intended that all such additional systems, methods, features, and advantages be included within this description, be within the scope of the present disclosure, and be protected by the following claims.

### BRIEF DESCRIPTION OF THE DRAWINGS

The above and other objects, features and advantages of the present disclosure will become more apparent to those of ordinary skill in the art by describing exemplary disclosures thereof in detail with reference to the accompanying drawings, in which:
FIG. 1 is a conceptual diagram of a display device according to one disclosure of the present disclosure;
FIG. 2 is a conceptual diagram of a touch panel according to one disclosure of the present disclosure;
FIG. 3 is a conceptual diagram of a touch electrode according to one disclosure of the present disclosure;
FIG. 4 is a partially enlarged view of FIG. 3;
FIG. 5 is a view showing a mesh-type touch electrode;
FIG. 6 is a cross-sectional view taken along line A-A' in FIG. 4;
FIGs. 7 to 9 are views showing various modified examples of a second opening hole formed in a touch electrode according to each embodiment of the present disclosure;
FIG. 10 is a conceptual diagram of a touch electrode according to another disclosure of the present disclosure;
FIG. 11 is a partially enlarged view of FIG. 10;
FIG. 12 is a cross-sectional view taken along line B-B' in FIG. 11;
FIG. 13 is a cross-sectional view taken along line C-C' in FIG. 11;
FIG. 14 is a view showing a connection structure of the touch electrode and an auxiliary electrode; and
FIGs. 15 and 16 are views showing various modified examples of an auxiliary electrode disposed in the touch electrode according to another disclosure of the present disclosure.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF EXEMPLARY DISCLOSURES

Advantages and features of the present disclosure and methods of achieving them will become apparent with reference to the following disclosures, which are described in detail, in conjunction with the accompanying drawings. However, the present disclosure is not limited to the disclosures to be described below and may be implemented in various different forms, the disclosures are only provided to completely disclose the present disclosure and completely convey the scope of the present disclosure to those skilled in the art.

Since the shapes, sizes, proportions, angles, numbers, and the like disclosed in the drawings for describing the disclosures of the present disclosure are only exemplary, the present disclosure is not limited to the items shown in the drawings. Names of the respective elements used in the following explanation are chosen only for convenience of description and may be different from those used in actual products. The same reference number indicates the same components throughout the specification. Further, in describing the present disclosure, when it is determined that a detailed description of related known technology may unnecessarily obscure the gist of the present disclosure, the detailed description thereof will be omitted or may be briefly discussed.

In the description of embodiments, when 'providing,' 'including,' 'having,' 'consisting of,' and the like mentioned in the present specification are used, other parts may be added unless 'only' is used. A case in which a component is expressed in a singular form may include a plural form unless explicitly stated otherwise.

In interpreting a component, the component is interpreted as including a margin of error even when there is no separate explicit description of the margin of error.

When a positional relationship and an interconnection relationship between two components such as 'on,' 'at an upper portion,' 'at a lower portion,' 'next to,' 'connect or couple,' 'crossing or intersecting,' or the like are described, one or more other components may be interposed between the components unless there is a mention such as 'immediately' or 'directly'. The directional terms such as "left," "right," "upper," and "lower" are used for convenience of explanation only and are interchangeable.

When temporal relationships are described as "after," "following," "and then," "before," and the like, it may not be continuous on a time axis unless "immediately" or "directly" is used.

First, second, and the like may be used to distinguish components, but the functions or structures of these components are not limited by the ordinal numbers in front of the components or component names.

The following disclosures may be partially or entirely combined with each other, and technically, various interconnections and operations are possible. The disclosures may be implemented independently of each other or together in a related relationship. Each of the embodiments as disclosed can be implemented independently, and the components and items from different embodiments can be combined with each other as alternative examples if necessary.

Hereinafter, various disclosures of the present disclosure will be described in detail with reference to the accompanying drawings.

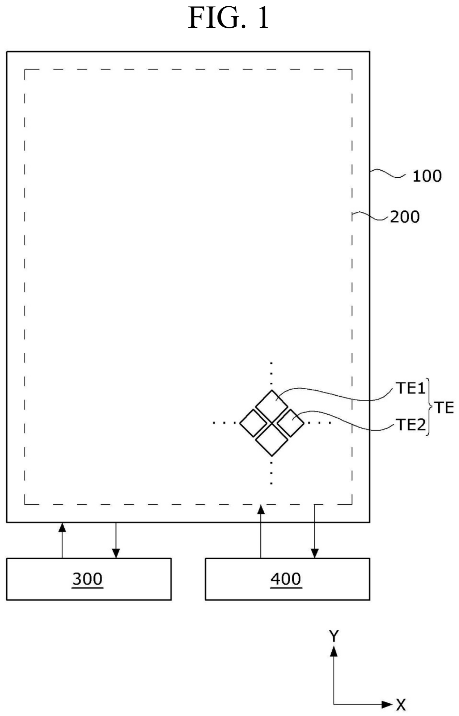

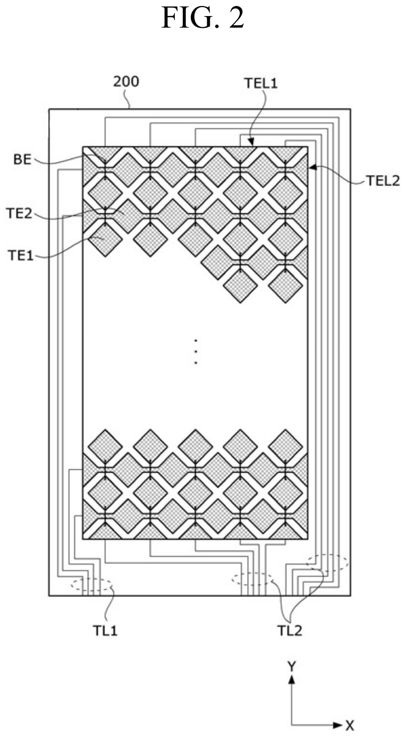

FIG. 1 is a conceptual diagram of a display device according to one disclosure of the present disclosure. FIG. 2 is a conceptual diagram of a touch panel according to one disclosure of the present disclosure.

Referring to FIGS. 1 and 2, the display device according to the disclosures may provide an image display function for displaying an image and a touch sensing function for sensing a user's touch.

The display device according to the disclosures may include a display panel 100 on which data lines and gate lines are disposed, and a data driver 300 for driving the display panel 100.

The data driver 300 may include a data driving circuit for driving the data lines, a gate driving circuit for driving the gate lines, a controller for controlling the data driving circuit and the gate driving circuit, and the like. The data driver 300 may be implemented with one or more integrated circuits.

The display device according to the disclosure may further include a touch panel 200 on which a plurality of touch electrodes TE are disposed and a plurality of touch lines TL1 and TL2 electrically connected to all or some of the plurality of touch electrodes TE are disposed, and a touch circuit portion 400 which drives the touch panel 200 to sense the presence or absence of a touch or a touch position.

The touch circuit portion 400 may supply a touch driving signal to a first touch electrode TE1 to drive the touch panel 200 and detect a touch sensing signal from a second touch electrode TE2 to sense the presence or absence of the touch and/or the touch position (touch coordinates).

The touch circuit portion 400 may include a touch driving circuit which supplies the touch driving signal and receives the touch sensing signal, a touch controller which calculates the touch coordinates, and the like. The touch driving signal may be a direct current signal having a constant voltage value, or may also be an alternating current signal which swings between a high level and a low level with a predetermined amplitude and is formed of a plurality of pulses.

The touch circuit portion 400 may be implemented with one or more components (for example, integrated circuits) and may be separately implemented from the data driver 300. However, the disclosures are not limited thereto. All or part of the touch circuit portion 400 may be implemented to be integrated with the data driver 300. For example, the touch driving circuit of the touch circuit portion 400 may be implemented as an integrated circuit along with the data driving circuit of the data driver 300.

The touch panel 200 may sense a touch using a mutual-capacitance-based touch sensing method which is a capacitance-based touch sensing method. In the case of the mutual-capacitance-based touch sensing method, the presence or absence of the touch and/or the touch coordinates may be detected based on a change in capacitance (mutual capacitance) between a driving electrode and a sensing electrode depending on the presence or absence of a pointer such as a finger, a pen, or the like. However, the disclosures are not limited thereto, and the touch may also be sensed using a self-capacitance-based touch sensing method.

In the case of the self-capacitance-based touch sensing method, each touch electrode TE may serve as both the driving electrode and the sensing electrode.

That is, the touch driving signal may be applied to each touch electrode TE, and the touch sensing signal may be received through the touch electrode TE to which the touch driving signal is applied. Accordingly, in the self-capacitance-based touch sensing method, there is no distinction between the driving electrode and the sensing electrode.

In the self-capacitance-based touch sensing method, the presence or absence of the touch and/or the touch coordinates may be detected based on a change in capacitance between a pointer such as a finger, a pen, or the like and the touch electrode TE.

Hereinafter, the mutual-capacitance-based touch sensing method will be described.

The plurality of touch electrodes TE may include the first touch electrode TE1 to which a touch driving signal is applied, and the second touch electrode TE2 which senses a touch sensing signal. The first touch electrode TE1 may be defined as a driving electrode, a touch driving electrode, a driving touch electrode, or the like, and the second touch electrode TE2 may be defined as a sensing electrode, a touch sensing electrode, a sensing touch electrode, or the like.

A plurality of first touch electrodes TE1 may be connected to each other in a second direction (a Y-axis direction) to form a driving electrode line TEL1, and a plurality of second touch electrodes TE2 may be connected to each other in a first direction (an X-axis direction) to form a sensing electrode line TEL2. The plurality of second touch electrodes TE2 may be connected to each other by a bridge electrode BE. However, the present disclosure is not limited thereto, and the plurality of first touch electrodes TE1 may be connected to each other by the bridge electrode BE.

In the disclosure, the plurality of first touch electrodes TE1 are described as being connected in the second direction, but the disclosures are not limited thereto. For example, the plurality of first touch electrodes TE1 may be connected to each other in the first direction to form the driving electrode line, and the plurality of second touch electrodes TE2 may be connected to each other in the second direction to form the sensing electrode line.

The touch panel 200 may include the touch lines TL1 and TL2 connected to the touch circuit portion 400 to electrically connect the touch electrodes TE and the touch circuit portion 400. The touch electrodes TE and the touch lines TL1 and TL2 may be disposed on the same layer or on different layers.

The touch panel 200 according to the disclosures may be disposed in the display panel 100, but is not limited thereto. For example, the touch panel 200 may be disposed on the outside of the display panel 100. When the touch panel 200 is an external type, the touch panel 200 and the display panel 100 may be separately manufactured through different panel manufacturing processes and then bonded. When the touch panel 200 is a built-in type, the touch panel 200 and the display panel 100 may be manufactured together through a single panel manufacturing process.

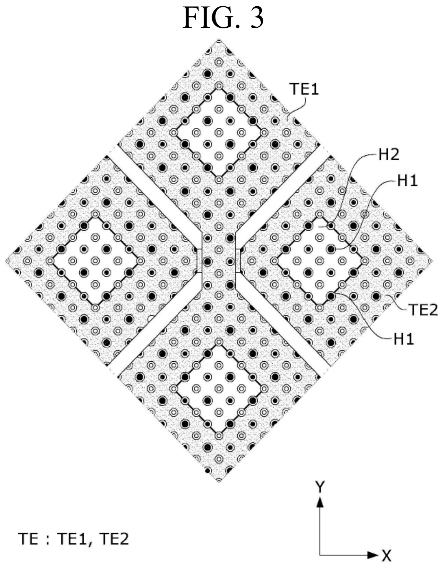

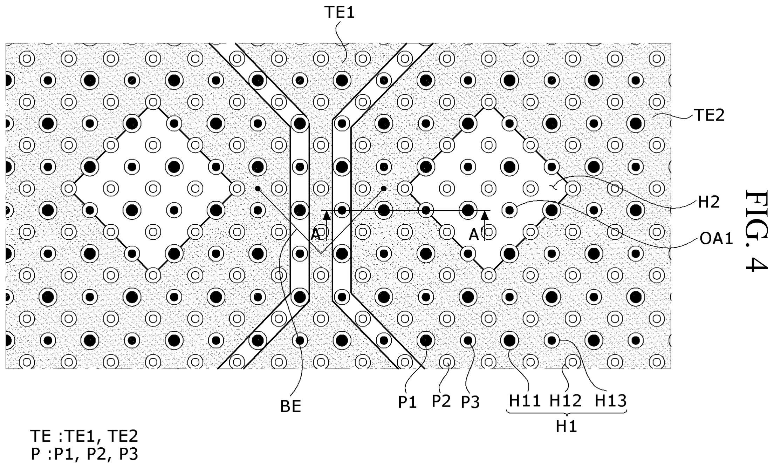

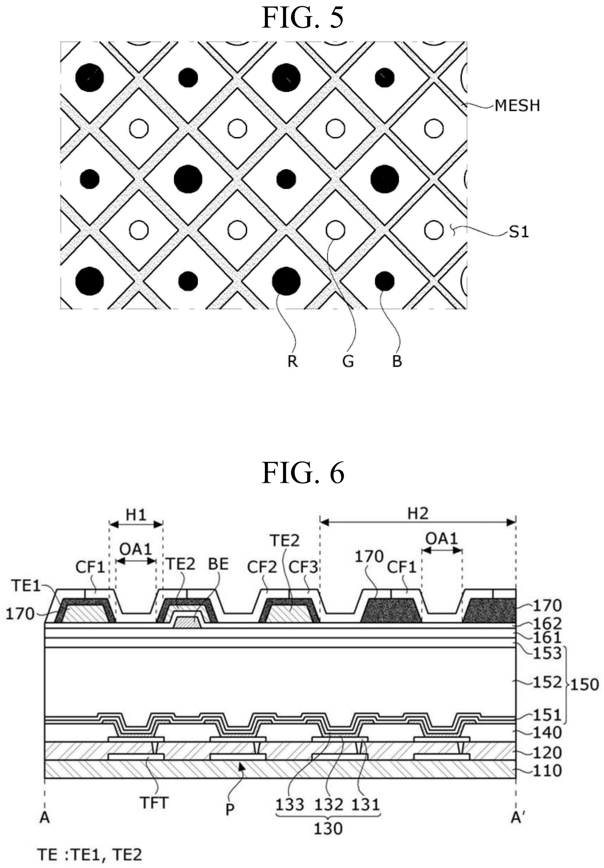

FIG. 3 is a conceptual diagram of the touch electrode according to one disclosure of the present disclosure. FIG. 4 is a partially enlarged view of FIG. 3. FIG. 5 is a view showing a mesh-type touch electrode.

Referring to FIGS. 3 and 4, the touch electrodes TE may include the first touch electrode TE1 disposed in the second direction (e.g. Y direction) and the second touch electrode TE2 disposed in the first direction (e.g. X direction). The disclosures are not limited thereto and the first touch electrode TE1 may be disposed in the first direction, while the second touch electrode TE2 may be disposed in the second direction. The first touch electrode TE1 may be a driving electrode and the second touch electrode TE2 may be a sensing electrode, but the disclosures are not limited thereto. For example, the first touch electrode TE1 may be a sensing electrode and the second touch electrode TE2 may be a driving electrode.

A shape of the touch electrode TE may be a quadrangular shape, but is not limited thereto. For example, the touch electrode TE may have a polygonal shape such as an octagonal shape.

The touch electrode TE may include a first opening hole H1 and a second opening hole H2 which expose a plurality of pixels. The first opening hole H1 may have a size sufficient to expose each pixel P. The first opening hole H1 may have a different diameter depending on the size of the pixel P. The first opening hole H1 may include a 1-1 opening hole H11 which exposes a first pixel P1, a 1-2 opening hole H12 which exposes a second pixel P2, and a 1-3 opening hole H13 which exposes a third pixel P3. For example, when the sizes of the pixels increase in the order of the second pixel P2, the third pixel P3, and the first pixel P1 (P2<P3<P1), the size of the first opening hole H1 may also increase in the order of the 1-2 opening hole H12, the 1-3 opening hole H13, and the 1-1 opening hole H11. That is, the diameter of the first opening hole H1 may vary depending on the size of the pixel. The first pixel P1 may be a red subpixel R, the second pixel P2 may be a blue subpixel B, and the third pixel P3 may be a green subpixel G, but the size of each pixel may vary. When the pixel further includes a white subpixel, the first opening hole H1 may further include a 1-4 opening hole which exposes the white subpixel. In embodiments of the present disclosure, the term "expose" may refer to ensure that the touch electrode does not cover the pixel or auxiliary electrode such that light from the pixel can emit to the outside. The plurality of first opening holes H1 may expose red subpixel R, blue subpixel B, and green subpixel G, respectively, and the second opening holes H2 may expose more pixels among the red subpixel R, blue subpixel B, and green subpixel G.

According to the disclosure, since the touch electrodes TE are disposed under a black matrix 170, the touch electrodes TE may not be visible from the outside. Accordingly, the touch electrodes TE may be disposed as widely as possible in a region where the black matrix 170 is disposed to improve sensing sensitivity. The black matrix 170 may overlap the top of the touch electrodes. In some embodiments, the black matrix 170 may overlap the top and side surfaces of the touch electrodes.

The touch electrode TE may be formed on the touch panel using vacuum equipment having a set allowable limit of a metal density at which the process may proceed. Due to process window control requirements, it is necessary to set ranges for local metal pattern density, wherein it is typically unallowable to make a complete coverage of metal patterns, which may violate process design rules. In the present disclosure, the allowable limit of the metal density set in the vacuum equipment may mean a density occupied by metal in the vacuum equipment. However, it is not necessarily limited to this and may also refer to the allowable metal density of vacuum equipment. Each vacuum equipment may have a set allowable metal density depending on the vacuum level.

Accordingly, when the allowable limit of the metal density is high, a large amount of metal may be injected into the vacuum equipment and thus the touch electrode TE may be widely formed, but when the allowable limit of the metal density is low, the metal density in the vacuum equipment is low and thus it is difficult to form a large area for the touch electrode TE.

The allowable metal density may vary depending on the vacuum equipment. Accordingly, to meet the settings of the allowable limit of the metal density in the vacuum equipment to be used, it is necessary to adjust the area of the touch electrode TE.

According to the disclosure, the second opening hole H2 may be formed in the touch electrode TE. The second opening hole H2 may be disposed at a center of the touch electrode TE, but is not limited thereto. For example, the second opening hole H2 may be disposed at an edge of the touch electrode TE. The second opening hole H2 may be divided into a plurality of second opening holes H2. A total area of the second opening hole H2 in the touch electrode TE may be smaller than a total area of a plurality of first opening holes H1. However, the present disclosure is not limited thereto, and the total area of the second opening hole H2 in the touch electrode TE may be greater than or equal to the total area of the plurality of first opening holes H1.

The second opening hole H2 may be formed to adjust the area of the touch electrode TE according to the allowable limit of the metal density set in the vacuum equipment. In a conventional touch structure, dummy metal is left in a floating state to maintain constant reflectivity, but according to the disclosure, there is a difference in that a dummy metal is removed and the second opening hole H2 is formed to allow the vacuum process in the device design. Further, in the disclosure, since the touch electrode TE is disposed under the black matrix, a visibility issue does not occur even when the dummy metal is removed.

The second opening hole H2 may be formed to correspond to the shape of the touch electrode TE. For example, when the touch electrode TE has a quadrangular shape, the second opening hole H2 may also have a quadrangular shape. However, the disclosures are not limited thereto. For example, the touch electrode TE may have an octagonal shape and the second opening hole H2 may have a quadrangular shape.

Referring to FIG. 5, a touch electrode TE having a mesh structure has been conventionally used for visibility, but there is an issue that resistance relatively increases due to the increased opening area S1 of the thin mesh lines, and thus sensing sensitivity is low. However, according to the disclosure, since the touch electrode TE is entirely disposed under the black matrix 170, there is an advantage of disposing the touch electrode TE as widely as possible to lower the resistance.

FIG. 6 is a cross-sectional view taken along line A-A' in FIG. 4.

Referring to FIG. 6, the display device according to the disclosure may include a substrate 110, a plurality of pixels P disposed on the substrate 110, an encapsulation portion 150 disposed on the plurality of pixels, a plurality of touch electrodes TE disposed on the encapsulation portion 150, and the black matrix 170 disposed on the plurality of touch electrodes TE. Each of the plurality of pixels P may include a light-emitting element 130 and a driving circuit including a thin film transistor TFT.

The substrate 110 may include an insulating material. For example, the substrate 110 may include glass or plastic. A buffer layer may be disposed on the substrate 110. The buffer layer may reduce or prevent contamination by the substrate during the formation process of the driving circuit.

A driving circuit including a plurality of thin film transistors TFT may be disposed on the substrate 110. The thin film transistor TFT may generate a driving current corresponding to a data signal. The thin film transistor may be an oxide thin film transistor or a low temperature polycrystalline silicon (LTPS) thin film transistor.

A planarization layer 120 may remove a step caused by the driving circuit of each pixel. For example, an upper surface of the planarization layer 120 facing the substrate 110 may be a flat plane. The planarization layer 120 may include an organic insulating material. A plurality of insulating layers may be further disposed between the planarization layer 120 and the substrate 110.

The light-emitting element 130 may emit light of a specific color. For example, the light-emitting element 130 of each pixel may include a first electrode 131, a light-emitting layer 132, and a second electrode 133 sequentially stacked on the substrate 110.

The first electrode 131 may include a conductive material. The first electrode 131 may include a material having high reflectivity. For example, the first electrode 131 may include a metal such as aluminum (Al) or silver (Ag). In an alternative embodiment, the first electrode 131 may also be formed of aluminum (Al), copper (Cu), silver (Ag), nickel (Ni), palladium (Pd), or a combination thereof. The first electrode 131 may have a multilayer structure. For example, the first electrode 131 may have a structure in which a reflective electrode made of metal is positioned between transparent electrodes made of a transparent conductive material such as ITO or IZO. In another embodiment, the first electrode 131 may also be formed of an Ag/Pd/Cu (APC) alloy.

The light-emitting layer 132 may generate light having a brightness corresponding to a voltage difference between the first electrode 131 and the second electrode 133. For example, the light-emitting layer 132 may include an emission material layer EML including a light-emitting material. The light-emitting material may include an organic material, an inorganic material, or a hybrid material. For example, the display device according to the disclosure of the present specification may be an organic light-emitting display device including an organic light-emitting material.

The light-emitting layer 132 may have a multilayer structure. For example, the light-emitting layer 132 may include a hole injection layer HIL, a hole transport layer HTL, an electron transport layer ETL, and an electron injection layer EIL.

However, the disclosures of the present disclosure are not limited thereto. The light-emitting element 130 may include a light-emitting layer 132 including an inorganic material. In this case, the light-emitting layer 132 may include a micro-sized inorganic light-emitting layer.

The second electrode 133 may include a conductive material. The second electrode 133 may include a different material from the first electrode 131. The transmittance of the second electrode 133 may be greater than the transmittance of the first electrode 131. For example, the second electrode 133 may be a transparent electrode made of a transparent conductive material such as ITO or IZO. Accordingly, in the display device according to the disclosure of the present specification, light generated by the light-emitting layer 132 may be emitted to the outside through the second electrode 133.

A bank layer 140 may be located on the planarization layer 120. The bank layer 140 may define a light-emitting region in each pixel. For example, the bank layer 140 may cover an edge of the first electrode 131. The light-emitting layer 132 and the second electrode 133 may be sequentially stacked on a portion of the first electrode 131 exposed by the bank layer 140. The bank layer 140 may include an insulating material. For example, the bank layer 140 may include an organic insulating material.

At least a portion of the light-emitting layer 132 of each pixel may extend outside the pixel. For example, at least one of the hole injection layer HIL, the hole transport layer HTL, the electron transport layer ETL, and the electron injection layer EIL located in each pixel may extend onto the bank layer 140. At least one of the hole injection layer HIL, the hole transport layer HTL, the electron transport layer ETL, and the electron injection layer EIL located in each pixel may be simultaneously formed with a corresponding layer located in an adjacent pixel. For example, at least one of the hole injection layer HIL, the hole transport layer HTL, the electron transport layer ETL, and the electron injection layer EIL may be formed on the entire surface of the substrate 110.

The encapsulation portion 150 may be located on the light-emitting element of each pixel. The encapsulation portion 150 may reduce or prevent damage to the light-emitting element due to external moisture and impacts. For example, the light-emitting element 130 of each pixel may be completely covered by the encapsulation portion 150.

The encapsulation portion 150 may have a multilayer structure. For example, the encapsulation portion 150 may include a first encapsulation layer 151, a second encapsulation layer 152, and a third encapsulation layer 153. The first encapsulation layer 151, the second encapsulation layer 152, and the third encapsulation layer 153 may include insulating materials.

The second encapsulation layer 152 may include a different material from the first encapsulation layer 151 and the third encapsulation layer 153. For example, the first encapsulation layer 151 and the third encapsulation layer 153 may include an inorganic insulating material, and the second encapsulation layer 152 may include an organic insulating material. Accordingly, the damage to the light-emitting element due to external moisture and impacts may be effectively reduced or prevented.

Since the second encapsulation layer 152 is formed relatively thick, a step due to the light-emitting element may be removed by the second encapsulation layer 152. For example, an upper surface of the encapsulation portion 150 facing the substrate 110 may be a flat plane. Further, a parasitic capacitance between the second electrode 133 of the light-emitting element and the touch electrode TE may be reduced by the second encapsulation layer 152. A thickness of the second encapsulation layer 152 may be 5 µm or more, but is not limited thereto.

A first touch insulating layer 161 may be disposed on the encapsulation portion 150. The first touch insulating layer 161 may block a chemical solution such as a developer or an etchant used in a manufacturing process of the touch electrodes TE, or external moisture or foreign substances from penetrating into the light-emitting element.

The bridge electrode BE may be disposed on the first touch insulating layer 161. The bridge electrode BE may be disposed at a position which connects the plurality of second touch electrodes TE2 among the touch electrodes TE. The bridge electrode BE may include the same material as the touch electrode TE, but may also include different materials.

A second touch insulating layer 162 may be disposed on the first touch insulating layer 161 to cover the bridge electrode BE and insulate the bridge electrode BE and the touch electrode TE. The second touch insulating layer 162 may be disposed between the bridge electrodes BE and may insulate the bridge electrodes BE from each other. Some of the second touch electrodes TE2 may be connected to the bridge electrodes BE by through holes.

The first touch insulating layer 161 and/or the second touch insulating layer 162 may be made of an inorganic insulating material such as silicon nitride (SiNₓ) or silicon oxide (SiOₓ).

The black matrix 170 may be located on the touch electrode TE. According to the disclosure, since the black matrix 170 is disposed on the touch electrode TE, external light may be reduced or prevented from being reflected by the touch electrode TE. Accordingly, the touch electrodes TE may be disposed as widely as possible.

The black matrix 170 may include a plurality of opening regions OA1, and the plurality of opening regions OA1 may be disposed at positions overlapping the first opening holes H1 of the touch electrode TE. Accordingly, light emitted from the light-emitting element 130 may be emitted to the outside through the first opening hole H1 and the opening region OA1. As can be seen from Fig.6, the area of the first opening H1 can correspond to the gap between the two adjacent first touch electrodes TE1 and second touch electrodes TE2. The opening region OA1 may correspond to the distance between two adjacent black matrix 170.The first opening hole H1 of the touch electrode TE may have a wider diameter than the opening region OA1 of the black matrix 170. In this embodiment, the black matrix 170 may cover the upper and side surfaces of the touch electrode, which facilitates the invisibility of the touch electrode TE. However, the embodiments of the invention are not limited thereto. The black matrix 170 can overlap with the touch electrode in other ways.

In the second opening hole H2 of the touch electrode TE, the black matrix 170 may be disposed on the second touch insulating layer 162. The second opening hole H2 may overlap a plurality of opening regions OA1 of the black matrix 170. That is, one first opening hole H1 overlaps one opening region OA1, but one second opening hole H2 may overlap a plurality of opening regions OA1. Referring to Fig. 6, it can also be seen that the second opening hole H2 may be a partial area where no touch electrode exists. In this case, the first touch electrode TE1 and the second touch electrode TE2 are not arranged in the area of the second opening hole H2. The black matrix 170 is disposed on the touch insulating layer without covering the touch electrode. In some embodiments, a region where touch electrodes are provided may be referred to as the first region, while the region where no touch electrodes are provided may be referred to as the second region.

According to the disclosure, the black matrix 170 may be directly disposed on the touch electrode TE, but is not limited thereto. For example, a separate touch protection layer may be disposed between the touch electrode TE and the black matrix 170.

The touch protection layer may be disposed on the touch electrode TE. The touch protection layer may serve to reduce or prevent oxidation, corrosion, or damage to the touch electrode TE and the touch line. The touch protection layer may be made of at least one materials among inorganic insulating materials such as silicon nitride (SiNₓ) and silicon oxide (SiOₓ), or organic insulating materials such as an acrylic resin, an epoxy resin, a phenolic resin, a polyamide resin, and a polyimide resin, but is not limited thereto.

Color filters CF1, CF2, and CF3 may be disposed in the opening regions OA1 of the black matrix 170. Color filters having the same color as the light emitted from each light-emitting element 130 may be disposed as the color filters CF1, CF2, and CF3, respectively. According to the disclosure, as a plurality of color filters CF1, CF2, and CF3 may be located at positions corresponding to the plurality of opening regions, excellent light-emitting performance may be achieved.

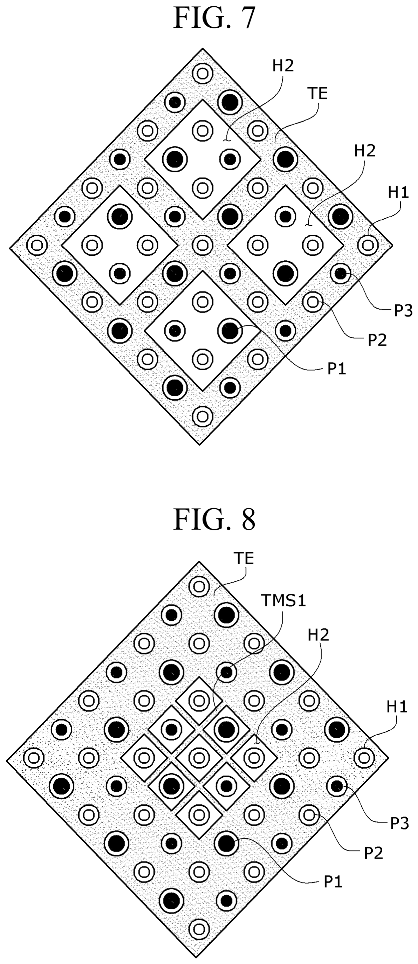

FIGS. 7 to 9 are views showing various modified examples of the touch electrodes.

Referring to FIG. 7, the touch electrode TE may include a plurality of first opening holes H1 and a plurality of second opening holes H2. According to the disclosure, the second opening hole H2 may be divided into a plurality of second opening holes H2 and disposed spaced apart from each other. When the second opening holes H2 are disposed at a predetermined interval, since the resistance distribution in the touch electrodes TE becomes more uniform, sensing sensitivity may be improved. In the embodiment shown in Fig. 7, the second opening holes H2 is arranged symmetrically around the central region of the touch electrode. The symmetrical arrangement may be advantageous in some embodiments for improving sensing sensitivity. However, in some other embodiments, the arrangement of the second opening hole H2 may not be exactly symmetrical (as shown in Fig.3).

Referring to FIG. 8, a plurality of conductive lines TMS1 may be formed in the second opening holes H2 of the touch electrode TE. According to this configuration, sensing sensitivity may be improved by forming the plurality of conductive lines TMS1 in the second opening holes H2 while maintaining the metal density. In other words, one or more conductive lines TMS1 are inserted in areas where no touch electrode TE exists to improve sensing sensitivity. The density of one or more conductive lines TMS1 may be lower than the arrangement density of touch electrodes TE.

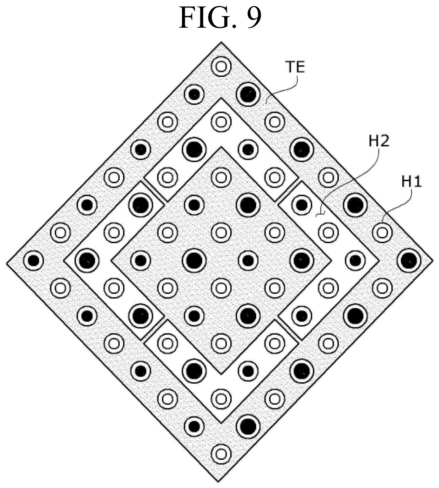

Referring to FIG. 9, the second opening hole H2 may be disposed at an edge of the touch electrode TE. In this case, the second opening hole H2 may be formed by connecting the plurality of first opening holes H1. The second opening hole H2 extends along the edge of the touch electrode TE and covers multiple first openings holes H1. The shape of one or more second opening holes H2 can be substantially the same as the shape of the touch electrode TE. For instance, if the touch electrode TE is quadrilateral, the one or more second opening hols H2 may also be quadrilateral and surround the central portion of the touch electrode TE. A width of the second opening hole H2 may be greater than or equal to a diameter of the first opening hole H1. In this way, the position and shape of the second opening hole H2 may be variously modified within a range which satisfies the metal density.

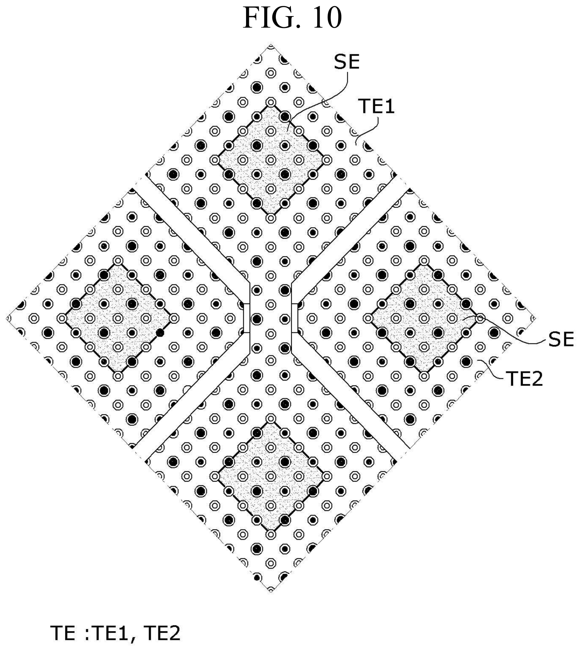

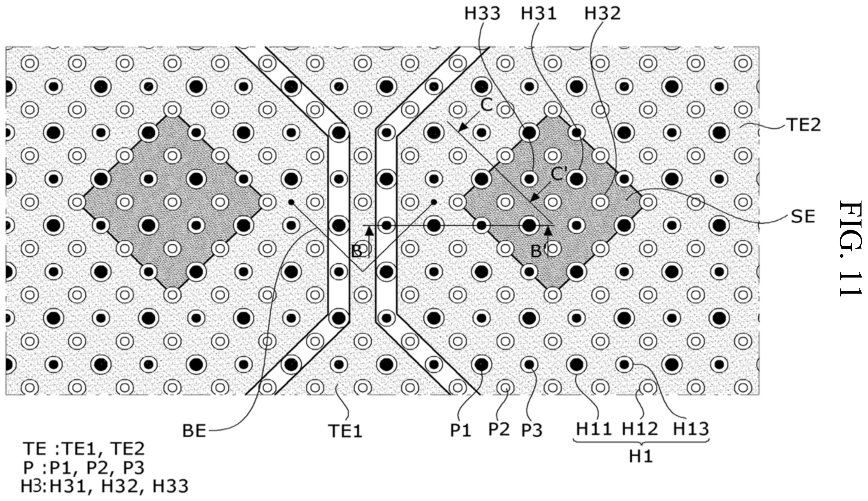

FIG. 10 is a conceptual diagram of a touch electrode according to another disclosure of the present disclosure. FIG. 11 is a partially view of in FIG. 10.

Referring to FIGS. 10 and 11, a touch electrode TE may include a first opening hole H1 and a second opening hole H2 which expose a plurality of pixels. The first opening hole H1 may have a size sufficient to expose one pixel P. The first opening hole H1 may have a different diameter depending on a size of the pixel P.

The first opening hole H1 may include a 1-1 opening hole H11 which exposes a first pixel P1, a 1-2 opening hole H12 which exposes a second pixel P2, and a 1-3 opening hole H13 which exposes a third pixel P3.

For example, when the sizes of the pixels increase in the order of the second pixel P2, the third pixel P3, and the first pixel P1 (P2<P3<P1), the size of the first opening hole H1 may also increase in the order of the 1-2 opening hole H12, the 1-3 opening hole H13, and the 1-1 opening hole H11. That is, the diameter of the first opening hole H1 may vary depending on the size of the pixel P.

According to the disclosure, the second opening hole H2 may be formed in the touch electrode TE. The second opening hole H2 may be disposed at a center of the touch electrode TE, but is not limited thereto. For example, the second opening hole H2 may be disposed at an edge of the touch electrode TE. The second opening hole H2 may be formed to adjust a metal density of the touch electrode TE.

The touch electrode TE may include an auxiliary electrode SE exposed through the second opening hole H2. The auxiliary electrode SE may be disposed on the same layer as the bridge electrode BE. The auxiliary electrode SE may be manufactured simultaneously with the bridge electrode BE. A touch sensing region may have substantially the same area as the black matrix 170 due to the auxiliary electrode SE. In this embodiment, the auxiliary electrode SE fills the region corresponding to the second opening holes H2 on a different layer from the touch electrode TE. The auxiliary electrode SE and the touch electrode TE may be spaced apart from each other by the second touch insulating layer 162. In this structure, the touch electrode TE, the bridging electrode BE, and the auxiliary electrode SE meet the limitations on the metal occupancy of each layer in semiconductor design. Moreover, sensing sensitivity may be further improved.

The auxiliary electrode SE may be formed to correspond to a shape of the touch electrode TE. For example, when the touch electrode TE has a quadrangular shape, the auxiliary electrode SE may also have a quadrangular shape. However, the disclosures are not limited thereto. For example, the touch electrode TE may have an octagonal shape and the auxiliary electrode SE may have a quadrangular shape.

An area of the auxiliary electrode SE may be smaller than an area of the touch electrode TE. Since the auxiliary electrode SE may be formed to correspond to an area where the second opening hole H2 is formed to adjust an electrode density, the auxiliary electrode SE may have a smaller area than the touch electrode TE. However, the disclosures are not limited thereto. For example, when the size of the touch electrode TE is reduced, the area of the auxiliary electrode SE may be greater than or equal to the area of the touch electrode TE.

The auxiliary electrode SE may have a shape corresponding to the second opening hole H2. For example, when the second opening hole H2 has a quadrangular shape, the auxiliary electrode SE may also have a quadrangular shape. However, the present disclosure is not limited thereto, and the auxiliary electrode SE may have a different shape from the second opening hole H2. For example, the second opening hole H2 may have a quadrangular shape while the auxiliary electrode SE may have an octagonal shape.

The auxiliary electrode SE may have a smaller area than the second opening hole H2. When the auxiliary electrode SE has an area greater than the area of the second opening hole H2, it overlaps the touch electrode TE, resulting in parasitic capacitance. However, the present disclosure is not limited thereto, and the auxiliary electrode SE may have an area greater than or equal to the area of the second opening hole H2.

The auxiliary electrode SE may include a third opening hole H3 which exposes a plurality of pixels P. The third opening hole H3 may have the same diameter as the first opening hole H1. Accordingly, the third opening hole H3 may include a 3-1 opening hole H31 which exposes a first pixel P1, a 3-2 opening hole H32 which exposes a second pixel P2, and a 3-3 opening hole H33 which exposes a third pixel P3. A diameter of the 3-1 opening hole H31 may be the same as a diameter of the 1-1 opening hole H11. A diameter of the 3-2 opening hole H32 may be the same as a diameter of the 1-2 opening hole H12. A diameter of the 3-3 opening hole H33 may be the same as a diameter of the 1-3 opening hole H13.

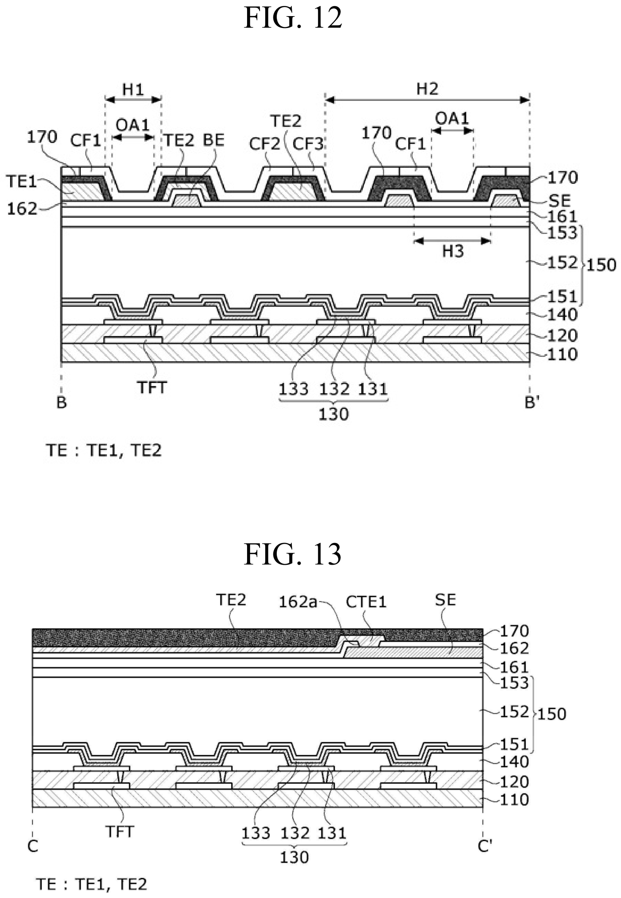

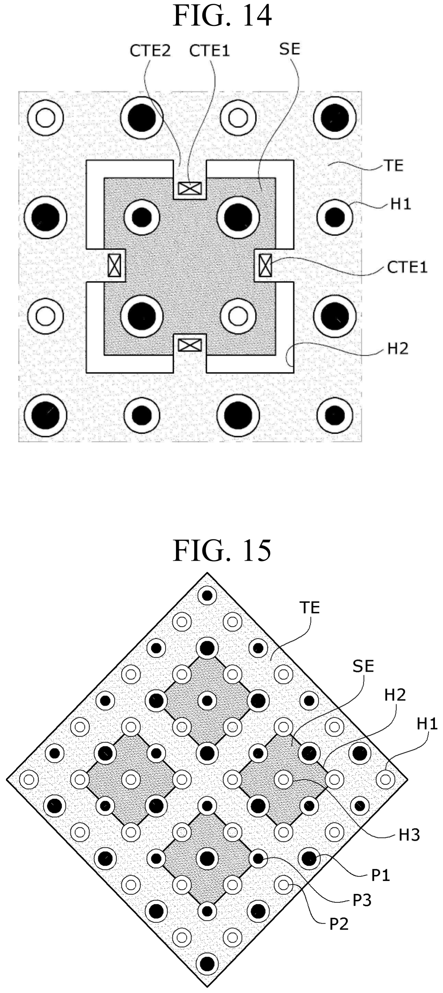

FIG. 12 is a cross-sectional view taken along line B-B' in FIG. 11. FIG. 13 is a cross-sectional view taken along line C-C' in FIG. 11. FIG. 14 is a view showing a connection structure of the touch electrode and the auxiliary electrode.

Referring to FIG. 12, a bridge electrode BE and an auxiliary electrode SE may be disposed on a first touch insulating layer 161. A second touch insulating layer 162 may be disposed on the bridge electrode BE and the auxiliary electrode SE. The first touch insulating layer 161 and/or the second touch insulating layer 162 may be made of an inorganic insulating material such as silicon nitride (SiNₓ) or silicon oxide (SiOₓ).

The bridge electrode BE and the auxiliary electrode SE are manufactured in the same process, and thus may be made of the same material and may have the same thickness. However, the disclosure is not limited thereto. For example, the bridge electrode and the auxiliary electrode SE may have different thicknesses. The thickness of the auxiliary electrode SE may be manufactured the same as that of the touch electrode TE to uniformize sensing sensitivity.

According to some embodiments of the disclosure, since the touch electrode TE is formed after forming the second touch insulating layer 162 on the auxiliary electrode SE, the auxiliary electrode SE may not affect the metal electrode density required by vacuum equipment. Accordingly, according to the disclosure, since the auxiliary electrode SE is formed first and then the touch electrode TE is formed, a sensing region may be improved or maximized while satisfying limitation of the metal density set in the vacuum equipment.

In a region where the second opening hole H2 is formed, only the auxiliary electrode SE may be disposed without the touch electrode TE. Accordingly, in the region where the second opening hole H2 is formed, the auxiliary electrode SE may serve as the touch electrode TE.

The black matrix 170 may be located on the touch electrode TE. According to the disclosure, since the black matrix 170 is disposed on the touch electrode TE and the auxiliary electrode SE, external light may be reduce or prevented from being reflected by the touch electrode TE and the auxiliary electrode SE. Accordingly, the touch electrode TE and the auxiliary electrode SE may be disposed as widely as possible.

In the second opening hole H2, the black matrix 170 may be disposed on the auxiliary electrode SE. In this case, the second touch insulating layer 162 may be disposed between the black matrix 170 and the auxiliary electrode SE. The black matrix 170 may overlap the top of the auxiliary electrode SE, and the side of the black matrix 170 may laterally overlap the side surface of the auxiliary electrode SE.

According to the disclosure, an opening region OA1 of the black matrix 170 may be disposed at a position overlapping the first opening hole H1 of the touch electrode TE. Accordingly, light emitted from the light-emitting element may be emitted to the outside through the first opening hole H1 and the opening region OA1.

The black matrix 170 may be disposed on the second touch insulating layer 162 in a portion corresponding to the second opening hole H2 of the touch electrode TE. Accordingly, one second opening hole H2 may overlap a plurality of opening regions OA1 of the black matrix 170.

The first opening hole H1 of the touch electrode TE may have a wider diameter than the opening region OA1 of the black matrix 170. Further, the third opening hole H3 of the auxiliary electrode SE may have a wider diameter than the first opening hole H1 of the touch electrode TE and the opening region OA1 of the black matrix 170. In this embodiment, the width of the opening region OA1 may correspond to the distance between the opposite side edges of two adjacent black matrices covering the auxiliary electrode SE, and the width of the third opening hole H3 may correspond to the distance between the opposite side edges of two adjacent auxiliary electrodes SE.

According to the disclosure, the black matrix 170 may be directly disposed on the touch electrode TE, but is not limited thereto. For example, a separate touch protection layer may be disposed between the touch electrode TE and the black matrix 170.

Referring to FIGS. 13 and 14, since a through hole 162a is formed in the second touch insulating layer 162, a contact electrode CTE1 of the touch electrode TE may be electrically connected to the auxiliary electrode SE through the through hole 162a.

There may be a plurality of contact electrodes CTE1 of the touch electrode TE. The touch electrode TE may include a plurality of extending portions CTE2 extending into the second opening hole H2, and the contact electrodes CTE1 may be disposed at ends of the extending portions CTE2. Although the drawing shows that the touch electrode TE and the auxiliary electrode SE are spaced apart in a plan view, the auxiliary electrode SE may be formed with the same area as the second opening hole H2 of the touch electrode TE. Accordingly, the touch electrode TE and the auxiliary electrode SE may be disposed so that boundaries thereof overlap.

Although the disclosure shows that the extending portions of the touch electrode TE extend to an upper portion of the auxiliary electrode SE, the disclosures are not limited thereto. For example, extending portions of the auxiliary electrode SE may extend and may be electrically connected to a lower portion of the touch electrode TE.

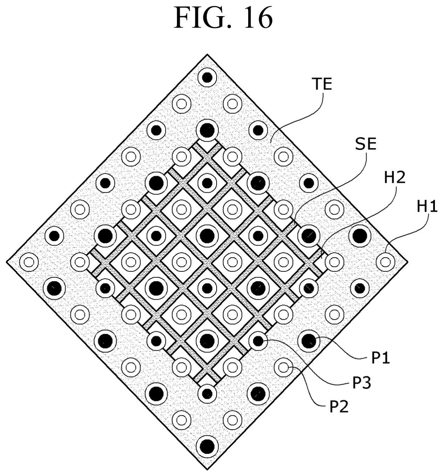

FIGS. 15 and 16 are views showing various modified examples of the touch electrode.

Referring to FIG. 15, the second opening hole H2 and the auxiliary electrode SE may be divided into a plurality of second opening holes H2 and auxiliary electrodes SE, and disposed spaced apart from each other. When the second opening holes H2 are disposed at a predetermined interval, since the resistance distribution in the touch electrodes TE becomes more uniform, sensing sensitivity may be improved. In this plan view of Fig.15, the auxiliary electrode SE may cover the entire area of the second opening holes H2. However, the embodiment is not limited thereto. The auxiliary electrode SE may cover a portion of the area of the second opening holes H2.

Referring to FIG. 16, the auxiliary electrode SE may have a mesh shape. According to this configuration, sensing sensitivity may be improved by forming a plurality of conductive lines in the second opening holes H2 while maintaining the metal density.

According to the disclosure of embodiments of the present invention, low reflectivity is possible and a visibility issue can be improved by disposing a touch electrode under a black matrix. Further, sensing sensitivity can be increased by increasing an area of the touch electrode. In addition, there is an advantage in securing touch performance as sensor design freedom increases.

In addition, the area of the touch electrode can be increased while adjusting the area of the touch electrode according to a metal density of vacuum equipment which manufactures a touch panel.

The effects of the present disclosure are not limited to the above-mentioned effects, and other effects which are not mentioned can be clearly understood by those skilled in the art from the following description.

Since the contents of the specification described in the problem to be solved, the means to solve the problem, and the effects described above do not specify the essential features of the claims, the scope of the claims is not limited by the items described in the contents of the specification. The scope of the present disclosure should be determined only by the appended claims and their equivalents.

Although the disclosures have been described in more detail with reference to the accompanying drawings, the present disclosure is not necessarily limited to these disclosures, and may be variously modified without departing from the technical idea of the present disclosure. Accordingly, the disclosures disclosed in the present disclosure are not intended to limit the technical idea of the present disclosure, but intended to describe the same, and the scope of the technical idea of the present disclosure is not limited by these disclosures. The scope of the present disclosure should be construed according to the appended claims, and all technical ideas within the equivalent range should be construed as being included in the scope of the present disclosure.

## Claims

1. A display device comprising:
a substrate;
a plurality of pixels disposed on the substrate;
an encapsulation portion disposed on the plurality of pixels;
a plurality of touch electrodes disposed on the encapsulation portion; and
a black matrix disposed on the plurality of touch electrodes,
wherein the plurality of touch electrodes include:
a plurality of first opening holes exposing the plurality of pixels, respectively, and
a second opening hole larger than the plurality of first opening holes.

2. The display device of claim 1, wherein the plurality of touch electrodes are disposed to overlap the black matrix.

3. The display device of claim 1 or 2, wherein each of the plurality of first opening holes exposes one pixel, and
the plurality of first opening holes have different sizes from each other.

4. display device of claim 3, wherein the second opening hole exposes more pixels than the first opening hole.

5. The display device of any preceding claim, wherein the plurality of touch electrodes include:
a plurality of first touch electrodes arranged in a first direction; and
a plurality of second touch electrodes arranged in a second direction intersecting the first direction, and
the second opening hole is disposed in each of the plurality of first touch electrodes and second touch electrodes.

6. The display device of any of claims 2 to 5, wherein a total area of the second opening hole in the touch electrode is smaller than a total area of the plurality of first opening holes.

7. The display device of any preceding claim, comprising a mesh pattern disposed in the second opening holes,
wherein the mesh pattern is electrically connected to the touch electrode.

8. The display device of any of claims 5 to 7, comprising an auxiliary electrode disposed to overlap the second opening hole.

9. The display device of claim 8, further comprising a bridge electrode connecting the plurality of second touch electrodes,
wherein the auxiliary electrode is disposed on the same layer as the bridge electrode.

10. The display device of claim 9, further comprising:
a first touch insulating layer disposed on the encapsulation portion; and
a second touch insulating layer disposed on the bridge electrode and the auxiliary electrode,
wherein the bridge electrode electrically connects the plurality of second touch electrodes, and
the auxiliary electrode is electrically connected to the touch electrode formed with the second opening hole by a through hole disposed in the second touch insulating layer.

11. The display device of any of claims 8 to 10, wherein the auxiliary electrode has a mesh shape.

12. The display device of claim 1 further comprising:
a touch insulating layer disposed on the auxiliary electrode; and
a plurality of touch electrodes disposed on the touch insulating layer.

13. The display device of claim 12, wherein the auxiliary electrode further includes a plurality of third opening holes that expose each of the plurality of pixels, and
the third opening holes are larger than the first opening holes.

14. The display device of claim 12 or 13, wherein each of the plurality of first opening holes exposes one pixel, and
the plurality of first opening holes have different sizes from each other.

15. The display device of any preceding claim wherein the black matrix covers an upper surface and side surface of the touch electrodes.
